# EUROPEAN PATENT APPLICATION

(11) **EP 4 626 174 A1**
(43) Date of publication of application: **01.10.2025**
(21) Application number: 25151800.7
(22) Date of filing: 14.01.2025
(51) Int. Cl.: H10D 84/01, H10D 88/00, H10D 30/00, H10D 30/01, H10D 30/67, H10D 62/10

(54) **DEEP VIA BACKSIDE (DVB) PARTIAL RECESS FOR CAPACITANCE REDUCTION IN COMPLEMENTARY FET (CFET) TRANSISTORS**

(30) Priority: 28.03.2024 US 202418619725
(71) Applicant: INTEL Corporation, Santa Clara, CA 95054 (US)
(72) Inventor: CHU, Tao, Portland, 97229 (US); XU, Guowei, Portland, 97229 (US); HUANG, Chiao-Ti, 244 New Taipei City (TW); CHAO, Robin, Portland, 97209 (US); ZHANG, Feng, Hillsboro, 97123 (US); HUNG, Ting-Hsiang, Beaverton, 97007 (US); ZHANG, Yang, Rio Rancho, 87124 (US); ZHANG, Kan, Portland, 97123 (US); YEUNG, Chun Wing, Portland, 97229 (US); JANG, Minwoo, Portland, 97229 (US); LUO, Yanbin, Portland, 97229 (US); PACKAN, Paul A., Hillsboro, 97124 (US); LIN, Chung-Hsun, Portland, 97229 (US); LIN, Chia-Ching, Portland, 97229 (US); MURTHY, Anand S., Portland, 97229 (US); ZHONG, Yue, Portland, 97229 (US)
(74) Representative: Goddar, Heinz J.

(57) **Abstract**

A stacked complementary field-effect device (CFET) device includes a bottom contact region and a top contact region. A first transistor layer of a first type is over the bottom contact region and a second transistor layer of a second type is over the first transistor layer. The top contact region is over the second transistor layer. The CFET device may include a backside wall extending between the top contact region and the bottom contact region, the backside wall adjacent to the top contact region, the transistor layer, and the second transistor layer, the backside wall comprising a partially recessed portion that includes a metal material on the bottom contact region and a dielectric material over the metal material that extends up to the top contact region.

## Description

### BACKGROUND

The demand for logic devices and memory devices has increased. This demand is further amplified due to the integration of accelerators such as Tile Matrix Multiply (TMUL) units, Advanced Vector Extensions (AVX) and Vision Processing Units (VPU) to support new workloads. RibbonFETs, or gate-all-around (GAA) FETs, are a new transistor architecture that is a default candidate for supporting these workloads and enabling n-chip higher density. However, complementary field effect transistors (CFETs), such as ribbonFETs, face performance issues due to parasitic capacitance challenges associated with process scaling.

### BRIEF DESCRIPTION OF THE DRAWINGS

FIG. 1A depicts a perspective view of a complementary field-effect transistor (CFET) transistor.
FIG. 1B depicts an example layout view of a front side (FS) of an array of CFET cells.
FIG. 1C depicts an example cross-sectional parallel-to-gate side view of a stacked CFET device in a CFET cell FIG. 1A along cross-section line A.
FIG. 2A depicts an example layout view of a front side (FS) of an array of CFET cells in accordance with the disclosed embodiments.
FIG. 2B depicts an example cross-sectional parallel-to-gate side view of a stacked CFET device in a CFET cell in FIG. 2A along the cross-section line B.
FIG. 2C depicts an example cross-sectional parallel-to-gate side view of a stacked CFET device in a CFET cell in FIG. 2A along the cross-section line C.
FIG. 2D depicts an example cross-sectional orthogonal to gate side view of DVB wall in FIG. 2A along the cross-section line D.
FIG. 3A depicts a graph of DVB recess depth values versus performance/yield values.
FIG. 3B depicts a graph of DVB recess depth values versus CEFF values.
FIG. 3C depicts a graph of DVB recess depth values versus line resolution values.
FIGS. 4A-4F are diagrams illustrating cross-sectional PGD over TCN views showing a fabrication process of a stacked CFET device using a DVD area resize mask according to the disclosed embodiments.
FIG. 5 illustrates an example of components that may be present in a computing system for implementing the techniques (e.g., operations, processes, methods, and methodologies) described herein.

### DESCRIPTION OF THE EMBODIMENTS

Methods and architectures for partially recessing deep via backside (DVB) for capacitance reduction in complementary FET (CFET) transistors are described. In the following detailed description, reference is made to the accompanying drawings that form a part hereof wherein like numerals designate like parts throughout, and in which is shown by way of illustration embodiments that may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims and their equivalents.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order than the described embodiment. Various additional operations may be performed and/or described operations may be omitted in additional embodiments.

The terms "substantially," "close," "approximately," "near," and "about," generally refer to being within +/-10% of a target value. Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, the phrases "A and/or B" and "A or B" mean (A), (B), or (A and B). For the purposes of the present disclosure, the phrase "A, B, and/or C" means (A), (B), (C), (A and B), (A and C), (B and C), or (A, B, and C).

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

As used herein, the term "circuitry" may refer to, be part of, or include an Application Specific Integrated Circuit (ASIC), an electronic circuit, a processor (shared, dedicated, or group), a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

The terms "coupled," "communicatively coupled," along with derivatives thereof are used herein. The term "coupled" may mean two or more elements are in direct physical or electrical contact with one another, may mean that two or more elements indirectly contact each other but still cooperate or interact with each other, and/or may mean that one or more other elements are coupled or connected between the elements that are said to be coupled with each other. The term "directly coupled" may mean that two or more elements are in direct contact with one another. The term "communicatively coupled" may mean that two or more elements may be in contact with one another by a means of communication including through a wire or other interconnect connection, through a wireless communication channel or link, and/or the like.

One or more embodiments described herein are directed to structures and architectures for fabricating stacked CFET devices and CFET arrays in which a deep via backside (DVB) is partially recessed for capacitance reduction in complementary FET (CFET) transistors. Embodiments may include or pertain to one or more of CFETs with backside power, SRAMs, and system-on-chip (SoC) technologies. One or more embodiments may be implemented to realize high-performance CFETs and SoCs of future technology nodes.

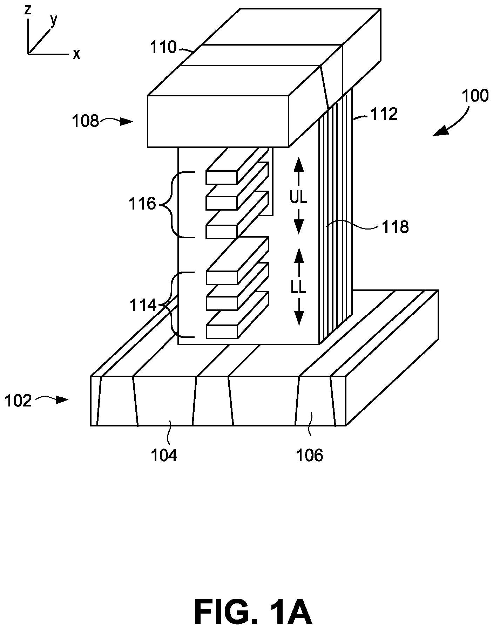

For context, FIG. 1A depicts a perspective view of a complementary field-effect transistor (CFET) device 100. The CFET is a product of an evolution of transistor technology from Fin Field-Effect Transistor (FinFET) to nanosheet FET to CFET. CFET enables a 50% front end scaling with nMOS transistors stacked vertically on top of pMOS transistors. CFET technology vertically stacks nNMOS and pMOS nanosheet or nanoribbon MOSFETs with a shared gate.

The bottom of the CFET device 100 includes a bottom contact region 102 comprising a substrate region with one or more metal lines 106 (part of a bottom metal layer). The substrate region 104 extends in an x-y plane. The top of CFET device 100 includes a top contact region 108 with a metal line 110 (part of a top metal layer). The bottom contact region 102 beneath the CFET device 100 is used to connect voltages/signals to the transistors.

An elevated region 112 includes a lower layer (LL), e.g., a first transistor layer 114 (an n-type transistor layer) with one or more nMOS transistors (nMOSFETs). An upper layer (UL), e.g., a second transistor layer 116 (n p-type transistor layer) with one or more pMOS transistors (pMOSFETs) over the lower layer (LL). The second transistor layer 116 may overlay, at least in part, and have an overlapping footprint with, the first transistor layer 114. In this example, each transistor includes three channels in the form of ribbons, where each channel is surrounded by a gate structure 118, as a gate-all-around transistor. The transistors can also be referred to as RibbonFETs. Three channels is an example, as 2-5 channels can be used, for example. nMOS source and drain regions (not shown) can be connected to pMOS source and drain regions (not shown) through vias since they are on different layers, e.g., the pMOS layer on the top and the nMOS layer on the bottom. In one embodiment, nMOS source and drain regions can be located on the backside of CFET device 100.

Dense CFET logic or memory cells using complementary transistors can be used in a variety of applications such as a system-on-a-chip (SOc) where density, performance and power consumption are bottlenecks. Other example applications include those with multiple integrated circuits within the same package, e.g., stacked tile/chiplet designs and other system-in-a-package designs that include multiple chips.

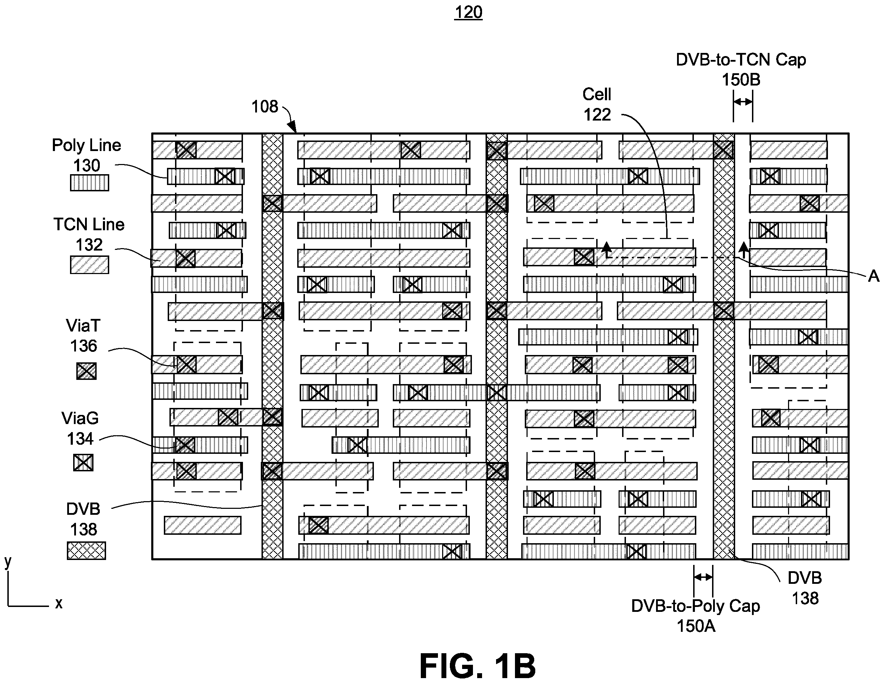

FIG. 1B depicts an example layout view of a front side (FS) of an array of CFET cells. The view is in the x-y plane looking from a top or front side of the cell (a side of the cell facing away from the substrate on which the cell if formed). In particular, the view depicts the metal lines in the top contact region 108 (FIG. 1A) or top metal layer. A region with an X generally denotes a via extending in the z direction, either toward or away from the substrate. The metal lines 110 may comprise various nodes, word lines and other conductive paths on the pMOS and nMOS layers may include a conductive material such as doped polysilicon. In some cases, the doped polysilicon contacts a source/drain region of a transistor as a trench contact (TCN).

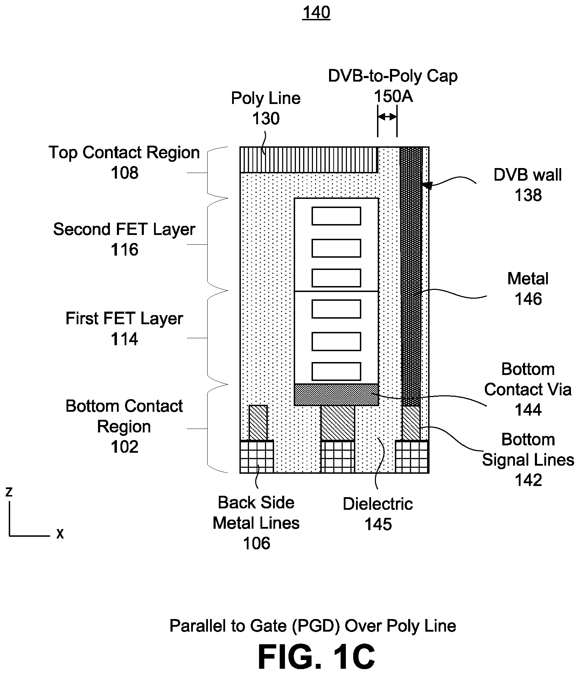

As depicted, the CFET array 120 comprises a plurality of CFET cells 122, denoted with a dashed outline. Each CFET cell 122 is located in a particular column of the CFET array 120 and comprises a plurality of CFET devices 140 (FIG. 1C), which are beneath the metal lines 110 of top contact region 108. Upper and lower-level transistor layers and the bottom or back side of the cell (a side of the cell facing the substrate) are not viewable. The CFET transistors of each CFET cell 122 occupy adjacent rows of the CFET array 120 in the γ-direction. The CFET devices 100 may be located in an n-type diffusion region or a p-type diffusion region.

The metal lines 110 comprising the top contact region 108 may include polysilicon (poly) lines 130 and trench contact (TCN) lines 132. The metal lines 110 may also include vias, which include gate contact vias (ViaG or VCG) 134 over poly lines 130 and TCN vias (ViaT or VCT) 136 over TCN lines 132.

The top contact region 108 further includes one or more deep via backside (DVB) walls 138 (also referred to as a backside wall or a via contact). The DVB walls 138 connect TCN lines 132 to a source or drain region in the backside or bottom contact region 102 through ViaT 136. As shown, DVB walls 138 may span a length of the CFET array 120 in the γ-direction and run adjacent to columns of the CFET cells 122. Along any given row of the CFET array 120, the DVB wall 138 may be adjacent to either a TCN line 132 or a poly line 130. In one embodiment, there is at least one column of CFET cells 122 between a pair of DVB walls 138.

FIG. 1C depicts an example cross-sectional parallel-to-gate side view of a stacked CFET device in a CFET cell 122 of FIG. 1B along cross-section line A, where like components from FIG. 1B have like reference numerals. Cross-section line A represents a parallel to gate (PGD) over a poly line view. Stacked CFET 140 is between bottom contact region 102 and top contact region 108. A first FET layer 114 of a first type is over the bottom contact region 102, and a second FET layer 116 of a second type is over the first FET layer 114. The top contact region 108 is over the second FET layer 116. In one embodiment, the first type is an N-type FET and the second type is a P-type FET. In another embodiment, the first type is a P-type FET and the second type is an N-type FET.

Bottom contact region 102 comprises metal lines 106 (bottom or backside metal lines) extending in a first direction (e.g., y-direction) in one or more bottom (backside) metal layers, e.g., BM0, BM1. Bottom contact region 102 further includes bottom signal lines 142, and bottom contact vias 144. The top contact region 108 comprises metal lines (top or front side metal lines) extending in a second direction (e.g., x-direction) orthogonal (+/- 5 degrees) to the first direction. The top metal lines are in one or more front side (top) metal layers, e.g., M0, M1. The top contact region 108 further includes top contact vias (e.g., ViaT 136 and ViaG 134). A dielectric 145 covers components of the stacked CFET 140.

In this view, poly line 130 is shown over the stacked CFET 140 in the top contact region 108. DVB wall is adjacent to metal lines (e.g. poly line 130 or TCN lines 132) in the top contact region 108, and adjacent to the first FET layer 114 and the second FET layer 116. DVB wall 138 extends in the z-direction between the top contact region 108, the first FET layer 114, the second FET layer 116, and the bottom contact region 102. In this example, the DVB wall terminates on bottom signal line 142 in the bottom contact region 102. DVB wall 138 is filled with a metal 146.

Locations on the DVB wall 138 that are adjacent to poly line 130 with no contact are referred to as DVB noncontact areas. Locations on the DVB where TCN line 132 crosses over and makes contact with DVB wall 138 through a ViaT 136 are referred to as DVB contact areas.

Because the DVB wall 138 is filled with metal 146 and is relatively large (extending in both the y- and z- directions), the metal 146 increases the parasitic capacitance between the DVB wall 138 and the poly lines 130 and between the DVB wall 138 and TCN lines 132, which are referred to as DVB-to-poly capacitance 150A and DVB-to-TCN capacitance 150B respectively. For device nodes less than 5nm, the parasitic capacitance degrades device performance.

In accordance with one or more embodiments described herein, non-planar structures effectively decrease parasitic capacitance by the partially recessing of metal in non-contact areas of the DVB wall and replacing the metal with a dielectric material. A stacked CFET device is provided which uses CFET technology, where a first layer (level) of transistors is in the device along with a second layer of transistors, with the first and second layers being in vertical alignment. The stacked CFET device includes a DVB wall adjacent to the first transistor layer and the second transistor layer, the DVB wall extending between a top contact region and a bottom contact region. The DVB wall comprises a metal portion on the bottom contact region and a recessed portion comprising a dielectric material over the metal portion. Applications of such systems may include, but are not limited to, back end (BEOL) logic, memory, or analog applications.

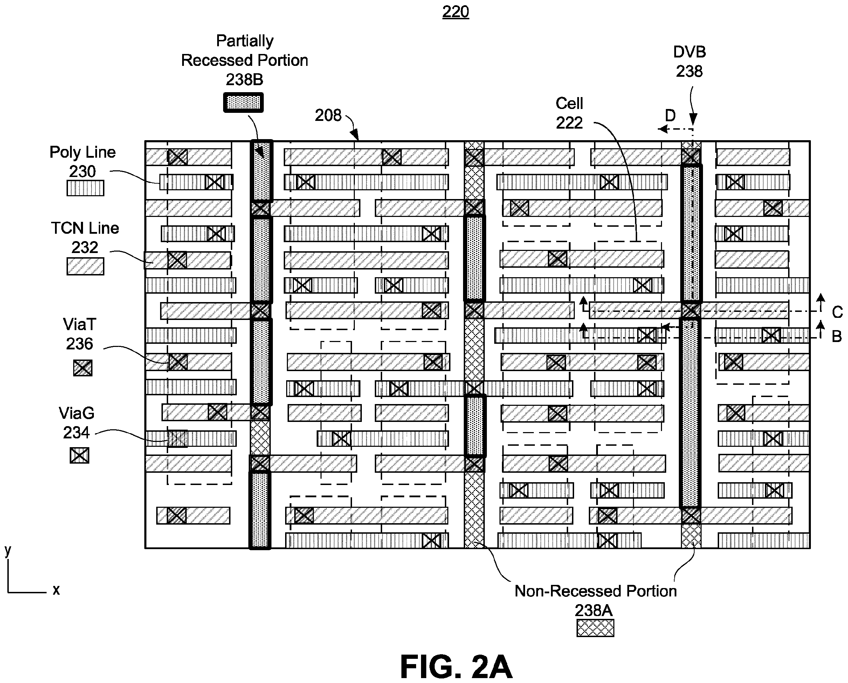

FIG. 2A depicts an example layout view of a front side (FS) of an array of CFET cells in accordance with the disclosed embodiments. The view is in the x-y plane looking from a top or front side of the cell (a side of the cell facing away from the substrate on which the cell is formed). In particular, the layout view depicts the metal lines in top contact region 208 or top metal layer. A region with an X generally denotes a via extending in the z direction, either toward or away from the substrate. The metal lines may comprise various nodes, word lines and other conductive paths on the pMOS and nMOS layers may include a conductive material such as doped polysilicon. In some cases, the doped polysilicon contacts a source/drain region of a transistor as a trench contact (TCN). The vias can include metal-plated through-vias, for example, or other conductive material. Nodes, word lines, and other conductive paths generally extend in an x-y plane while a via generally extends in the z-direction.

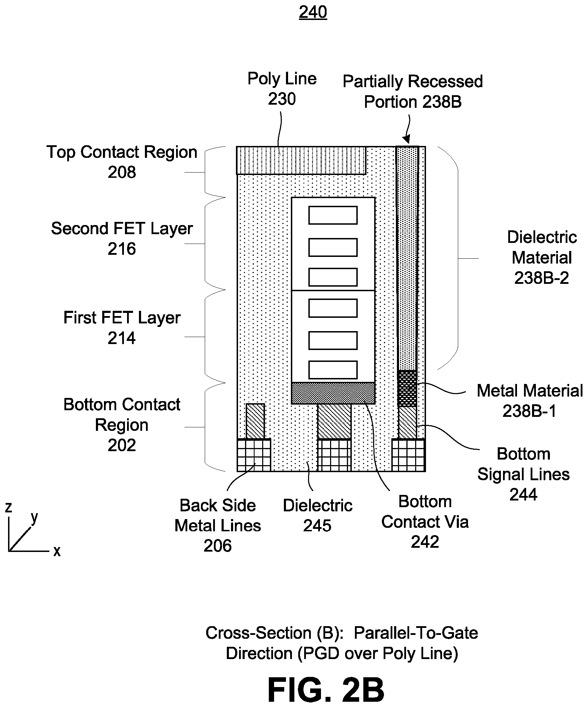

As depicted, the CFET array 220 comprises a plurality of CFET cells 222, denoted with a dashed outline. The CFET array 220 comprises a plurality of rows and columns, a bottom contact region, and a top contact region. The CFET cells 222 are located along particular columns of the CFET array 220 and comprise a plurality of CFET devices 240, as described in FIG. 2B. The lower-level transistor layer, the upper-level transistor layer, and the bottom contact region (a side of the cell facing the substrate) are not viewable. The CFET devices of each CFET cell 222 occupy adjacent rows of the CFET array 220 in the y-direction. The CFET devices may be located in an n-type diffusion region or a p-type diffusion region.

The metal lines comprising the top contact region 208 may include polysilicon (poly) lines 230 and trench contact (TCN) lines 232. The metal lines may also include vias, which include gate contact vias (ViaG or VCG) 234 over poly lines 230 and TCN vias (ViaT or VCT) 236 over TCN lines 232.

The top contact region 208 further includes one or more backside walls referred to herein as deep via backside (DVB) walls 238. The DVB walls 238 connect TCN lines 232 to a source or drain region in the backside or bottom contact region 202 through ViaT 236. As shown, the DVB walls 238 may be located adjacent to, and parallel with, columns of the CFET cells 222. In one embodiment, DVB walls 238 may or may not span the CFET array 220 in a y-direction. Along any given row of the CFET array 220, the DVB wall 238 may be adjacent to a contact line (e.g., poly line 230 or a TCN line 232). In one embodiment, there is at least one column of CFET cells 222 between a pair of DVB walls 238.

FIG. 2B depicts an example cross-sectional parallel-to-gate side view of a stacked CFET device in a CFET cell in FIG. 2A along the cross-section line B, where like components from FIG. 2A have like reference numerals. Cross-section line B represents a parallel to gate (PGD) over a poly line view.

Referring to both FIGS. 2A and 2B, stacked CFET device 240 structure is between bottom contact region 202 and top contact region 208. Bottom contact region 202 comprises backside metal lines 206 along a first direction (e.g., y-direction) in one or more bottom (backside) metal layers, e.g., BM0, BM1. Bottom contact region 202 further includes bottom signal lines 244, and bottom contact vias 242.

The top contact region 208 comprises top or front side metal lines (e.g., poly lines 230 and TCN lines 232) along in a second direction (e.g., x-direction) orthogonal (+/- 5 degrees) to the first direction. The top metal lines are in one or more front side (top) metal layers, e.g., M0, M1. The top contact region 208 further includes top contact vias (e.g., ViaT 236 and ViaG 234). In this view, TCN line 232 is over the stacked CFET device 240 in the top contact region 208.

Stacked CFET device 240 comprises a first FET layer 214 and a second FET layer 216. The first FET layer 214 of a first type is over the bottom contact region 202, and a second FET layer 216 of a second type is over the first FET layer 214. The top contact region 208 is over the second FET layer 216. In one embodiment, the first type is an N-type FET and the second type is a P-type FET. In another embodiment, the first type is a P-type FET and the second type is an N-type FET.

The first FET layer 214 and the second FET layer 216 may comprise a patterned workfunction (PWF), which refers to the formation of gate electrodes with different work functions for the n-channel and p-channel devices to optimize threshold voltages and performance of each transistor type. The p-type FET layer comprises a pWF metal layer stack and the n-type FET comprises an nWF metal layer stack, where the pWF metal layer stack and the nWF metal layer stack are in vertical alignment.

At least one DVB wall 238 is along the first direction (the y-direction) parallel with metal lines 206 in bottom contact region 202. DVB wall 238 is adjacent to the top metal lines, e.g. poly line 230 or TCN lines 232, over the stacked CFET device 240. DVB wall 238 extends down (in the z-direction) between the top contact region 208 and the bottom contact region 202 adjacent to the top contact region 208, the first FET layer 214, and the second FET layer 216. In this example, the DVB wall 238 terminates on bottom signal line 244 in the bottom contact region 202. A dielectric 245 covers components of the stacked CFET device 240 and the DVB wall 238 is formed through the dielectric 245.

In embodiments, the DVB wall 238 ranges from approximately 100 - 150 nm in z-direction height between the bottom contact region 202 and the top contact region 208. In embodiments, the DVB wall 238 ranges from 20 - 40 nm in width on the bottom contact region 202.

Locations along the DVB wall 238 in the y-direction adjacent to metal lines (e.g., poly line 230 or TCN line 232) that do not make contact with the DVB wall 238 in the top contact region 208 are referred to as noncontact areas of the DVB, as shown in FIG. 2B. In embodiments, a distance from the DVB wall 238 to the metal lines (e.g., poly line 230 or TCN line 232) in the noncontact areas of the DVB wall 238 may range from approximately 10-25 nm.

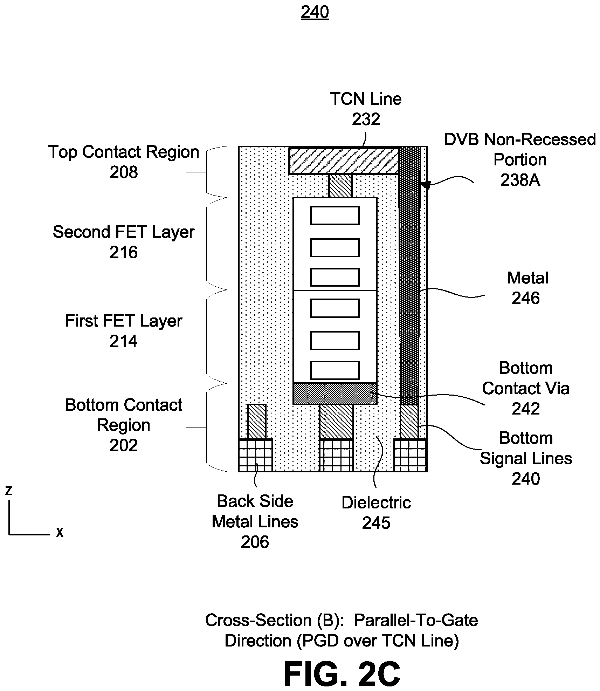

Locations along the DVB wall 238 where TCN lines 232 cross over the stacked CFET device 240 and make contact (e.g., through a ViaT 236) with DVB wall 238 are referred to as contact areas of the DVB, as shown in FIG. 2C.

FIG. 2C depicts an example cross-sectional parallel-to-gate side view of a stacked CFET device in a CFET cell 222 in FIG. 2A along the cross-section line C. Cross-section line C represents a parallel-to-gate (PGD) over a TCN line view. TCN line 232 crosses over and makes contact with DVB wall 238 through a top contact, such as a ViaT 236, which is one contact area. In contact areas, the DVB wall 238 is filled with metal 246 between the bottom contact region 202 and the top contact region 208.

Referring again to both FIGS. 2A and 2B, according to the disclosed embodiments, parasitic capacitance is reduced by modifying the DVB wall 238 in the noncontact areas by using a DVB mask to partially recess the metal 246 in the DVB wall 238 and replacing the metal with a dielectric 238B-2. The DVB wall 238 remains unmodified in the contact areas.

As a result, the DVB wall 238 comprises non-recessed portions 238A and partially recessed portions 238B. The non-recessed portions 238A in the contact areas comprise metal 246 between the bottom contact region 202 and the top contact region 208 (FIG. 2C). The partially recessed portions 238B comprise a metal material 238B-1 at a bottom of the DVB wall 238 on, and in contact with, the bottom contact region 202. The partially recessed portions 238B further comprise a dielectric material 238B-2 over metal material 238B-1, where the dielectric material 238B-2 extends up to the top contact region 208. In one embodiment, metal 246 and metal material 238B-1 comprise metals of the same type. In another embodiment, metal 246 and metal material 238B-1 may comprise metals of a different type.

In embodiments, the partially recessed portions 238B-2 of the DVB wall 238 may range in height (z-direction) from approximately 20 to 70 nm, while the metal material 238B-1 ranges in height (z-direction) from 30 - 80 nm.

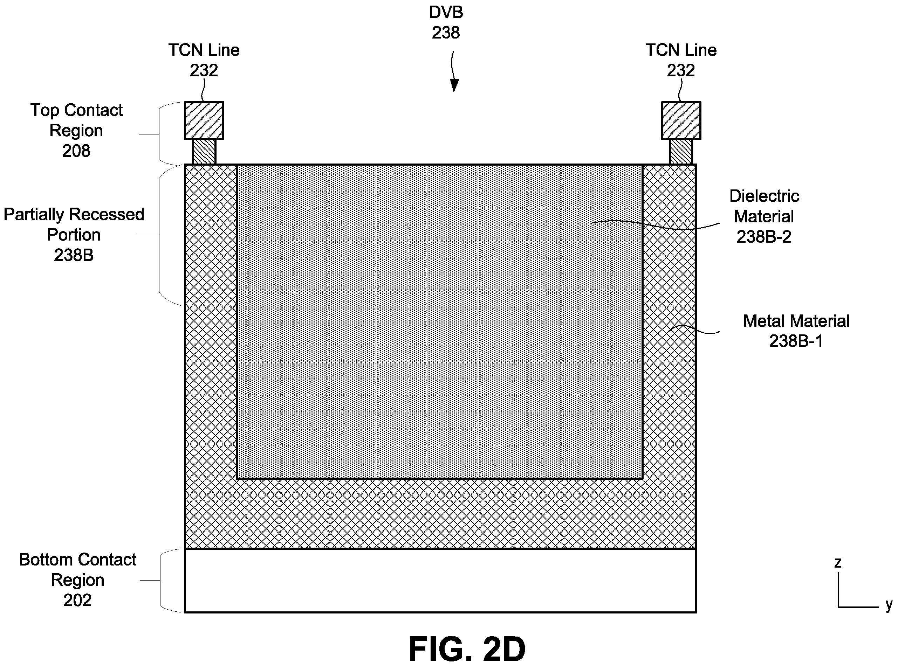

In one embodiment, the DVB wall 238 is recessed such that sidewalls of the partially recessed portion 238B contain no metal material. In another embodiment, the DVB wall 238 is recessed such that metal material 238B-2 is present in both a bottom of the DVB wall 238 on the bottom contact region 202 and also along the sidewalls of the partially recessed portions 238B, as shown in FIG. 2D.

FIG. 2D depicts an example cross-sectional orthogonal to gate side view of DVB wall in FIG. 2A along the cross-section line D. Cross-section line D represents an orthogonal to gate (OGD) direction view showing a cross-section the DVB wall 238 between two TCN contact areas. Two TCN lines 232 connect to DVB wall 238 through respective top contacts, such as a ViaT 236. This view shows that after a partial recess, metal material 238B-1 remains on the sidewalls and bottom of the DVB wall 238, while dielectric material 238B-2 replaces the metal material in the remainder of the DVB wall 238 up to the top contact region 208.

In embodiments, any suitable metal 246/238B-1 may be used for the DVB wall 238. In one embodiment metal 246/238B-1 may comprise tungsten, cobalt, or molybdenum for example. Any suitable the dielectric may be used for dielectric material 238B-2. In embodiments, the dielectric material 238B-2 may comprise silicon dioxide, silicon nitrite, or a mixture of both.

Because a majority of the metal 246 is removed from the partially recessed portions 238B of the DVB wall 238, there is less overall parasitic capacitance between the DVB wall 238 and adjacent poly lines 230. In accordance with the disclosed embodiments, by introducing new "partial" DVB recess and design technology co-optimization (DTCO) (a methodology that helps semiconductor fabs reduce cost and time-to-market in advanced process development), effective capacitance (CEFF) can be reduced by ~5% and performance of a stack CFET can be improved ~2-3%.

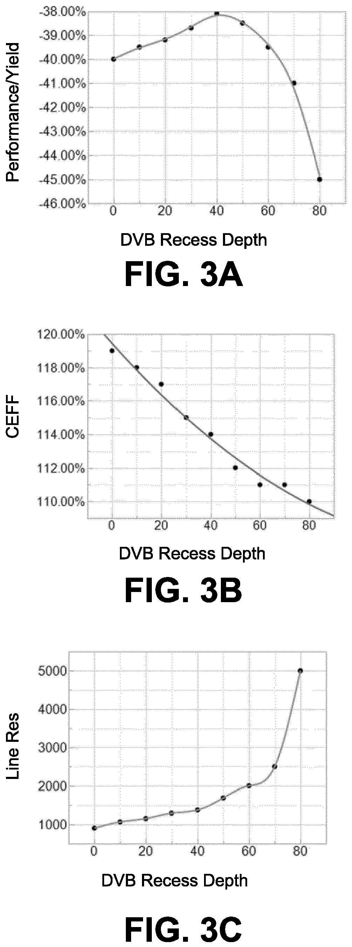

FIG. 3A depicts a graph of DVB recess depth values versus performance/yield values. FIG. 3B depicts a graph of DVB recess depth values versus CEFF values. FIG. 3C depicts a graph of DVB recess depth values versus line resolution values. All three graphs indicate that recessing DVB wall reduces CEFF and increases line resolution and a recess depth up to 60 nm is beneficial for device performance. Recess depths greater than 60-70 nm may make lines open and degrade performance/yield. A full recess will open lines and degrade performance/yield.

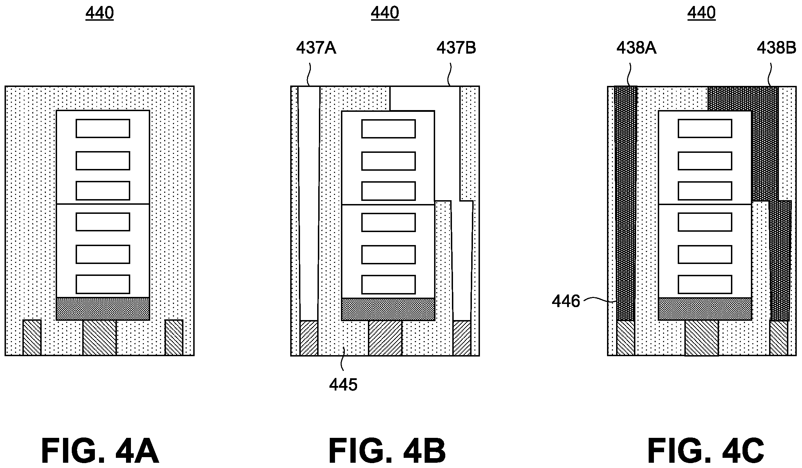

FIGS. 4A-4F are diagrams illustrating cross-sectional PGD over TCN views showing a fabrication process of a stacked CFET device using a DVD area resize mask according to the disclosed embodiments.

FIG. 4A is a diagram illustrating the fabrication process after the formation of a stacked CFET device 440.

FIG. 4B is a diagram illustrating an embodiment of where DVB trench 437A and DVB trench 437B are etched through a dielectric 445 adjacent to both sides of the stacked CFET device 440 to the bottom contact region (not shown). DVB trench 437A is etched in a noncontact area. DVB trench 437B is etched in a contact area to begin the process of forming a shared source contact. FIG. 4B also illustrates an embodiment where DVB trench 437B is formed in a double etch process that forms two trenches that are slightly offset.

FIG. 4C is a diagram illustrating a metal fill process where metal 446 is deposited in both DVB trench 437A and DVB trench 437B to form DVB wall 438A and DVB wall 438B. The process could end here but would result in a high amount of parasitic capacitance.

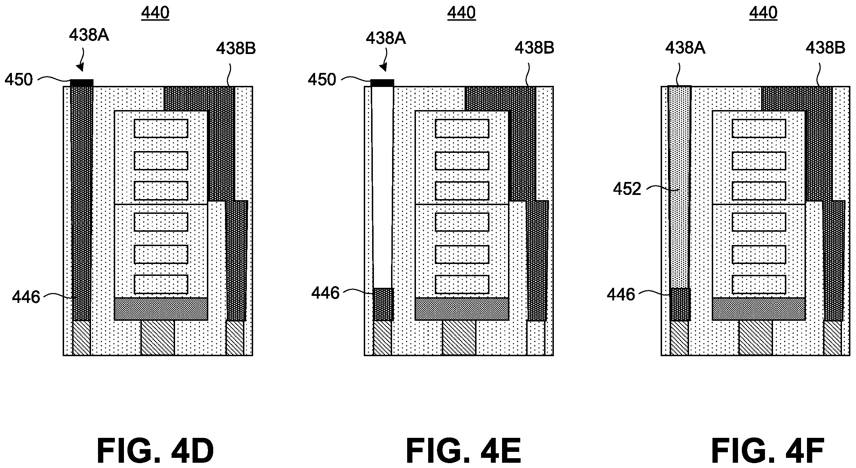

FIG. 4D is a diagram illustrating a masking process in which a DVB area resize mask 450 is applied over the DVB wall 438A in the noncontact area according to the disclosed embodiments.

FIG. 4E is a diagram illustrating a partial recess of the DVB wall 438A where the metal 446 is partially recessed. In one embodiment, the metal 446 can be partially recessed down to a level adjacent to the transistor layer on the bottom contact region.

FIG. 4F is a diagram illustrating that after the partial recess, a dielectric fill process is performed to fill the remainder of the DVB wall 438A with a dielectric material 452 from a top of the metal 446 to the top of DVB wall 438A.

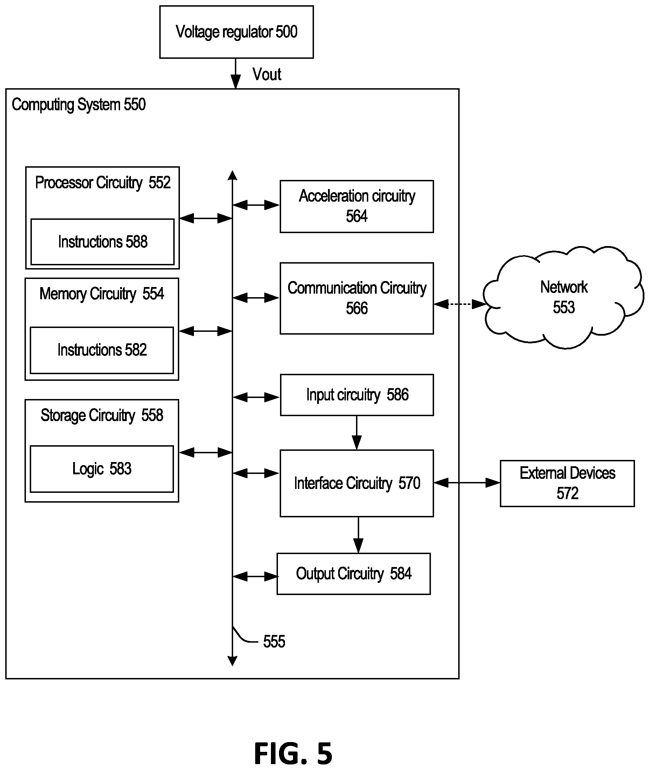

FIG. 5 illustrates an example of components that may be present in a computing system 550 for implementing the techniques (e.g., operations, processes, methods, and methodologies) described herein. The CFET memory cell described herein can be used in any of the components of the computing system 550. One example implementation involves the memory circuitry 554.

The voltage regulator 500 may provide a voltage Vout to one or more of the components of the computing system 550.

The memory circuitry 554 may store instructions and the processor circuitry 552 may execute the instructions to perform the functions described herein.

The computing system 550 may include any combinations of the hardware or logical components referenced herein. The components may be implemented as ICs, portions thereof, discrete electronic devices, or other modules, instruction sets, programmable logic or algorithms, hardware, hardware accelerators, software, firmware, or a combination thereof adapted in the computing system 550, or as components otherwise incorporated within a chassis of a larger system. For one embodiment, at least one processor 552 may be packaged together with computational logic 582 and configured to practice aspects of various example embodiments described herein to form a System in Package (SiP) or a System on Chip (SoC).

The system 550 includes processor circuitry in the form of one or more processors 552. The processor circuitry 552 includes circuitry such as, but not limited to one or more processor cores and one or more of cache memory, low drop-out voltage regulators (LDOs), interrupt controllers, serial interfaces such as SPI, I2C or universal programmable serial interface circuit, real time clock (RTC), timer-counters including interval and watchdog timers, general purpose I/O, memory card controllers such as secure digital/multi-media card (SD/MMC) or similar, interfaces, mobile industry processor interface (MIPI) interfaces and Joint Test Access Group (JTAG) test access ports. In some implementations, the processor circuitry 552 may include one or more hardware accelerators (e.g., same or similar to acceleration circuitry 564), which may be microprocessors, programmable processing devices (e.g., FPGA, ASIC, etc.), or the like. The one or more accelerators may include, for example, computer vision and/or deep learning accelerators. In some implementations, the processor circuitry 552 may include on-chip memory circuitry, which may include any suitable volatile and/or non-volatile memory, such as DRAM, SRAM, EPROM, EEPROM, Flash memory, solid-state memory, and/or any other type of memory device technology, such as those discussed herein

The processor circuitry 552 may include, for example, one or more processor cores (CPUs), application processors, GPUs, RISC processors, Acorn RISC Machine (ARM) processors, CISC processors, one or more DSPs, one or more FPGAs, one or more PLDs, one or more ASICs, one or more baseband processors, one or more radio-frequency integrated circuits (RFIC), one or more microprocessors or controllers, a multi-core processor, a multithreaded processor, an ultra-low-voltage processor, an embedded processor, or any other known processing elements, or any suitable combination thereof. The processors (or cores) 552 may be coupled with or may include memory/storage and may be configured to execute instructions stored in the memory/storage to enable various applications or operating systems to run on the platform 550. The processors (or cores) 552 is configured to operate application software to provide a specific service to a user of the platform 550. In some embodiments, the processor(s) 552 may be a special-purpose processor(s)/controller(s) configured (or configurable) to operate according to the various embodiments herein.

As examples, the processor(s) 552 may include an Intel^{®} Architecture Core^{™} based processor such as an i3, an i5, an i7, an i9 based processor; an Intel^{®} microcontroller-based processor such as a Quark^{™}, an Atom^{™}, or other MCU-based processor; Pentium^{®} processor(s), Xeon^{®} processor(s), or another such processor available from Intel^{®} Corporation, Santa Clara, California. However, any number other processors may be used, such as one or more of Advanced Micro Devices (AMD) Zen^{®} Architecture such as Ryzen^{®} or EPYC^{®} processor(s), Accelerated Processing Units (APUs), MxGPUs, Epyc^{®} processor(s), or the like; A5-A12 and/or S1-S4 processor(s) from Apple^{®} Inc., Snapdragon^{™} or Centriq^{™} processor(s) from Qualcomm^{®} Technologies, Inc., Texas Instruments, Inc.^{®} Open Multimedia Applications Platform (OMAP)^{™} processor(s); a MIPS-based design from MIPS Technologies, Inc. such as MIPS Warrior M-class, Warrior I-class, and Warrior P-class processors; an ARM-based design licensed from ARM Holdings, Ltd., such as the ARM Cortex-A, Cortex-R, and Cortex-M family of processors; the ThunderX2^{®} provided by Cavium^{™}, Inc.; or the like. In some implementations, the processor(s) 552 may be a part of a system on a chip (SoC), System-in-Package (SiP), a multi-chip package (MCP), and/or the like, in which the processor(s) 552 and other components are formed into a single integrated circuit, or a single package. Other examples of the processor(s) 552 are mentioned elsewhere in the present disclosure.

The system 550 may include or be coupled to acceleration circuitry 564, which may be embodied by one or more AI/ML accelerators, a neural compute stick, neuromorphic hardware, an FPGA, an arrangement of GPUs, one or more SoCs (including programmable SoCs), one or more CPUs, one or more digital signal processors, dedicated ASICs (including programmable ASICs), PLDs such as complex (CPLDs) or high complexity PLDs (HCPLDs), and/or other forms of specialized processors or circuitry designed to accomplish one or more specialized tasks. These tasks may include AI/ML processing (e.g., including training, inferencing, and classification operations), visual data processing, network data processing, object detection, rule analysis, or the like. In FPGA-based implementations, the acceleration circuitry 564 may comprise logic blocks or logic fabric and other interconnected resources that may be programmed (configured) to perform various functions, such as the procedures, methods, functions, etc. of the various embodiments discussed herein. In such implementations, the acceleration circuitry 564 may also include memory cells (e.g., EPROM, EEPROM, flash memory, static memory (e.g., SRAM, anti-fuses, etc.) used to store logic blocks, logic fabric, data, etc. in LUTs and the like.

In some implementations, the processor circuitry 552 and/or acceleration circuitry 564 may include hardware elements specifically tailored for machine learning and/or artificial intelligence (AI) functionality. In these implementations, the processor circuitry 552 and/or acceleration circuitry 564 may be, or may include, an AI engine chip that can run many different kinds of AI instruction sets once loaded with the appropriate weightings and training code. Additionally or alternatively, the processor circuitry 552 and/or acceleration circuitry 564 may be, or may include, AI accelerator(s), which may be one or more of the aforementioned hardware accelerators designed for hardware acceleration of AI applications. As examples, these processor(s) or accelerators may be a cluster of artificial intelligence (AI) GPUs, tensor processing units (TPUs) developed by Google^{®} Inc., Real AI Processors (RAPs^{™}) provided by AlphaICs^{®}, Nervana^{™} Neural Network Processors (NNPs) provided by Intel^{®} Corp., Intel^{®} Movidius^{™} Myriad^{™} X Vision Processing Unit (VPU), NVIDIA^{®} PX^{™} based GPUs, the NM500 chip provided by General Vision^{®}, Hardware 3 provided by Tesla^{®}, Inc., an Epiphany^{™} based processor provided by Adapteva^{®}, or the like. In some embodiments, the processor circuitry 552 and/or acceleration circuitry 564 and/or hardware accelerator circuitry may be implemented as AI accelerating co-processor(s), such as the Hexagon 685 DSP provided by Qualcomm^{®}, the PowerVR 2NX Neural Net Accelerator (NNA) provided by Imagination Technologies Limited^{®}, the Neural Engine core within the Apple^{®} A11 or A12 Bionic SoC, the Neural Processing Unit (NPU) within the HiSilicon Kirin 970 provided by Huawei^{®}, and/or the like. In some hardware-based implementations, individual subsystems of system 550 may be operated by the respective AI accelerating co-processor(s), AI GPUs, TPUs, or hardware accelerators (e.g., FPGAs, ASICs, DSPs, SoCs, etc.), etc., that are configured with appropriate logic blocks, bit stream(s), etc. to perform their respective functions.

The system 550 also includes system memory 554. Any number of memory devices may be used to provide for a given amount of system memory. As examples, the memory 554 may be, or include, volatile memory such as random access memory (RAM), static RAM (SRAM), dynamic RAM (DRAM), synchronous DRAM (SDRAM), RAMBUS^{®} Dynamic Random Access Memory (RDRAM^{®}), and/or any other desired type of volatile memory device. Additionally or alternatively, the memory 554 may be, or include, non-volatile memory such as read-only memory (ROM), erasable programmable ROM (EPROM), electrically erasable programmable (EEPROM), flash memory, non-volatile RAM, ferroelectric RAM, phase-change memory (PCM), flash memory, and/or any other desired type of non-volatile memory device. Access to the memory 554 is controlled by a memory controller. The individual memory devices may be of any number of different package types such as single die package (SDP), dual die package (DDP) or quad die package (Q17P). Any number of other memory implementations may be used, such as dual inline memory modules (DIMMs) of different varieties including but not limited to microDIMMs or MiniDIMMs.

Storage circuitry 558 provides persistent storage of information such as data, applications, operating systems and so forth. In an example, the storage 558 may be implemented via a solid-state disk drive (SSDD) and/or high-speed electrically erasable memory (commonly referred to as "flash memory"). Other devices that may be used for the storage 558 include flash memory cards, such as SD cards, microSD cards, XD picture cards, and the like, and USB flash drives. In an example, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, phase change RAM (PRAM), resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a Domain Wall (DW) and Spin Orbit Transfer (SOT) based device, a thyristor based memory device, a hard disk drive (HDD), micro HDD, of a combination thereof, and/or any other memory. The memory circuitry 554 and/or storage circuitry 558 may also incorporate three-dimensional (3D) cross-point (XPOINT) memories from Intel^{®} and Micron^{®}.

The memory circuitry 554 and/or storage circuitry 558 is/are configured to store computational logic 583 in the form of software, firmware, microcode, or hardware-level instructions to implement the techniques described herein. The computational logic 583 may be employed to store working copies and/or permanent copies of programming instructions, or data to create the programming instructions, for the operation of various components of system 550 (e.g., drivers, libraries, application programming interfaces (APIs), etc.), an operating system of system 550, one or more applications, and/or for carrying out the embodiments discussed herein. The computational logic 583 may be stored or loaded into memory circuitry 554 as instructions 582, or data to create the instructions 582, which are then accessed for execution by the processor circuitry 552 to carry out the functions described herein. The processor circuitry 552 and/or the acceleration circuitry 564 accesses the memory circuitry 554 and/or the storage circuitry 558 over the interconnect (IX) 566. The instructions 582 direct the processor circuitry 552 to perform a specific sequence or flow of actions, for example, as described with respect to flowchart(s) and block diagram(s) of operations and functionality depicted previously. The various elements may be implemented by assembler instructions supported by processor circuitry 552 or high-level languages that may be compiled into instructions 588, or data to create the instructions 588, to be executed by the processor circuitry 552. The permanent copy of the programming instructions may be placed into persistent storage devices of storage circuitry 558 in the factory or in the field through, for example, a distribution medium (not shown), through a communication interface (e.g., from a distribution server (not shown)), over-the-air (OTA), or any combination thereof.

The IX 566 couples the processor 552 to communication circuitry 566 for communications with other devices, such as a remote server (not shown) and the like. The communication circuitry 566 is a hardware element, or collection of hardware elements, used to communicate over one or more networks 553 and/or with other devices. In one example, communication circuitry 566 is, or includes, transceiver circuitry configured to enable wireless communications using any number of frequencies and protocols such as, for example, the Institute of Electrical and Electronics Engineers (IEEE) 802.11 (and/or variants thereof), IEEE 802.23.4, Bluetooth^{®} and/or Bluetooth^{®} low energy (BLE), ZigBee^{®}, LoRaWAN^{™} (Long Range Wide Area Network), a cellular protocol such as 3GPP LTE and/or Fifth Generation (5G)/New Radio (NR), and/or the like. Additionally or alternatively, communication circuitry 566 is, or includes, one or more network interface controllers (NICs) to enable wired communication using, for example, an Ethernet connection, Controller Area Network (CAN), Local Interconnect Network (LIN), DeviceNet, ControlNet, Data Highway+, or PROFINET, among many others.

The IX 566 also couples the processor 552 to interface circuitry 570 that is used to connect system 550 with one or more external devices 572. The external devices 572 may include, for example, sensors, actuators, positioning circuitry (e.g., global navigation satellite system (GNSS)/Global Positioning System (GPS) circuitry), client devices, servers, network appliances (e.g., switches, hubs, routers, etc.), integrated photonics devices (e.g., optical neural network (ONN) integrated circuit (IC) and/or the like), and/or other like devices.

In some optional examples, various input/output (I/O) devices may be present within or connected to, the system 550, which are referred to as input circuitry 586 and output circuitry 584. The input circuitry 586 and output circuitry 584 include one or more user interfaces designed to enable user interaction with the platform 550 and/or peripheral component interfaces designed to enable peripheral component interaction with the platform 550. Input circuitry 586 may include any physical or virtual means for accepting an input including, inter alia, one or more physical or virtual buttons (e.g., a reset button), a physical keyboard, keypad, mouse, touchpad, touchscreen, microphones, scanner, headset, and/or the like. The output circuitry 584 may be included to show information or otherwise convey information, such as sensor readings, actuator position(s), or other like information. Data and/or graphics may be displayed on one or more user interface components of the output circuitry 584. Output circuitry 584 may include any number and/or combinations of audio or visual display, including, inter alia, one or more simple visual outputs/indicators (e.g., binary status indicators (e.g., light emitting diodes (LEDs)) and multi-character visual outputs, or more complex outputs such as display devices or touchscreens (e.g., Liquid Crystal Displays (LCD), LED displays, quantum dot displays, projectors, etc.), with the output of characters, graphics, multimedia objects, and the like being generated or produced from the operation of the platform 550. The output circuitry 584 may also include speakers and/or other audio emitting devices, printer(s), and/or the like. Additionally or alternatively, sensor(s) may be used as the input circuitry 586 (e.g., an image capture device, motion capture device, or the like) and one or more actuators may be used as the output device circuitry 584 (e.g., an actuator to provide haptic feedback or the like). Peripheral component interfaces may include, but are not limited to, a non-volatile memory port, a USB port, an audio jack, a power supply interface, etc. In some embodiments, a display or console hardware, in the context of the present system, may be used to provide output and receive input of an edge computing system; to manage components or services of an edge computing system; identify a state of an edge computing component or service; or to conduct any other number of management or administration functions or service use cases.

The components of the system 550 may communicate over the IX 566. The IX 566 may include any number of technologies, including ISA, extended ISA, I2C, SPI, point-to-point interfaces, power management bus (PMBus), PCI, PCIe, PCIx, Intel^{®} UPI, Intel^{®} Accelerator Link, Intel^{®} CXL, CAPI, OpenCAPI, Intel^{®} QPI, UPI, Intel^{®} OPA IX, RapidIO^{™} system IXs, CCIX, Gen-Z Consortium IXs, a HyperTransport interconnect, NVLink provided by NVIDIA^{®}, a Time-Trigger Protocol (TTP) system, a FlexRay system, PROFIBUS, and/or any number of other IX technologies. The IX 566 may be a proprietary bus, for example, used in a SoC based system.

The number, capability, and/or capacity of the elements of system 550 may vary, depending on whether computing system 550 is used as a stationary computing device (e.g., a server computer in a data center, a workstation, a desktop computer, etc.) or a mobile computing device (e.g., a smartphone, tablet computing device, laptop computer, game console, IoT device, etc.). In various implementations, the computing device system 550 may comprise one or more components of a data center, a desktop computer, a workstation, a laptop, a smartphone, a tablet, a digital camera, a smart appliance, a smart home hub, a network appliance, and/or any other device/system that processes data.

The techniques described herein can be performed partially or wholly by software or other instructions provided in a machine-readable storage medium (e.g., memory). The software is stored as processor-executable instructions (e.g., instructions to implement any other processes discussed herein). Instructions associated with the flowchart (and/or various embodiments) and executed to implement embodiments of the disclosed subject matter may be implemented as part of an operating system or a specific application, component, program, object, module, routine, or other sequence of instructions or organization of sequences of instructions.

In various implementations, the computing device 500 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 500 may be any other electronic device that processes data.

The techniques described herein can be performed partially or wholly by software or other instructions provided in a machine-readable storage medium (e.g., memory). The software is stored as processor-executable instructions (e.g., instructions to implement any other processes discussed herein). Instructions associated with the flowchart (and/or various embodiments) and executed to implement embodiments of the disclosed subject matter may be implemented as part of an operating system or a specific application, component, program, object, module, routine, or other sequence of instructions or organization of sequences of instructions.

The storage medium can be a tangible, non-transitory machine readable medium such as read only memory (ROM), random access memory (RAM), flash memory devices, floppy and other removable disks, magnetic storage media, optical storage media (e.g., Compact Disk Read-Only Memory (CD ROMS), Digital Versatile Disks (DVDs)), among others.

The storage medium may be included, e.g., in a communication device, a computing device, a network device, a personal digital assistant, a manufacturing tool, a mobile communication device, a cellular phone, a notebook computer, a tablet, a game console, a set top box, an embedded system, a TV (television), or a personal desktop computer.

The above description of illustrated implementations of embodiments of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

Embodiment 1. A stacked complementary field-effect device transistor (CFET) device, comprising: a bottom contact region; a top contact region; a first transistor layer of a first type over the bottom contact region; a second transistor layer of a second type over the first transistor layer; a top contact region over the second transistor layer; and a backside wall extending between the top contact region and the bottom contact region, the backside wall adjacent to the top contact region, the transistor layer, and the second transistor layer, the backside wall comprising a partially recessed portion that includes a metal material on the bottom contact region and a dielectric material over the metal material that extends up to the top contact region.

Embodiment 2. The stacked CFET device of Embodiment 1, wherein the top contact region comprises a metal line that does not make contact with the backside wall in the top contact region.

Embodiment 3. The stacked CFET device of Embodiment 2, wherein a distance from the backside wall to the metal line in the top contact regions ranges from 10 - 25 nm.

Embodiment 4. The stacked CFET device of Embodiment 1, 2, or 3, wherein the partially recessed portion of the backside wall ranges in height from 20 to 70 nm.

Embodiment 5. The stacked CFET device of Embodiment 1, 2, 3, or 4, wherein the metal material ranges in height from 30 - 80 nm.

Embodiment 6. The stacked CFET device of Embodiment 1, 2, 3, 4, or 5, the backside wall ranges from 100 - 150 nm in height between the bottom contact region and the top contact regions.

Embodiment 7. The stacked CFET device of Embodiment 1, 2, 3, 4, 5, or 6, wherein the backside wall ranges from 20 - 40 nm in width on the bottom contact region.

Embodiment 8. The stacked CFET device of Embodiment 1, 2, 3, 4, 5, 6, or 7, wherein the backside wall is recessed such that sidewalls of the partially recessed portion contain no metal material.

Embodiment 9. The stacked CFET device of Embodiment 1, 2, 3, 4, 5, 6, 7, or 8, wherein the backside wall is recessed such that the metal material is present at both a bottom of the backside wall and along sidewalls of the partially recessed portions.

Embodiment 10. The stacked CFET device of Embodiment 1, 2, 3, 4, 5, 6, 7, 8, or 9, wherein the first type is an N-type FET and the second type is a P-type FET.

Embodiment 11. The stacked CFET device of Embodiment 1, 2, 3, 4, 5, 6, 7, 8, 9, or 10, wherein, the first type is a P-type FET and the second type is an N-type FET.

Embodiment 12. A stacked complementary field-effect device transistor (CFET) device, comprising: a bottom contact region comprising a first set of metal lines along a first direction; a transistor stack structure formed on the bottom contact region, the transistor stack structure comprising: p-type FET layer comprising a pWF metal layer stack; and an n-type FET comprising nWF metal layer stack, where the pWF metal layer stack and the nWF metal layer stack are in vertical alignment; a top contact region over the transistor stack structure, the top contact region comprising a second set of metal lines along a second direction over the transistor stack structure; and a deep via backside (DVB) wall along a first direction parallel with the first set of metal lines, the DVB wall extending down between the top contact region and the bottom contact regions and adjacent to top contact region, the p-type FET layer, and n-type FET layer, wherein the DVB wall comprises: non-recessed portions that are filled with metal between the bottom contact region and the top contact region; and partially recessed portions that comprise: i) a metal material on the bottom contact region; and ii) a dielectric material over the metal material, the dielectric material extending up to the top contact region.

Embodiment 13. The stacked CFET device of Embodiment 12, wherein the partially recessed portion of the DVB wall ranges in height from 20 to 70 nm.

Embodiment 14. The stacked CFET device of Embodiment 12 or 13, wherein the metal material ranges in height from 30 - 80 nm.

Embodiment 15. The stacked CFET device of Embodiment 12, 13, or 14, the DVB wall ranges from 100 - 150 nm in height between the bottom contact region and the top contact regions.

Embodiment 16. The stacked CFET device of Embodiment 12, 13, 14, or 15, wherein the DVB wall ranges from 20 - 40 nm in width on the bottom contact region.

Embodiment 17. The stacked CFET device of Embodiment 12, 13, 14, 15, or 16, wherein the DVB wall is recessed such that sidewalls of the partially recessed portions contain no metal material.

Embodiment 18. The stacked CFET device of Embodiment 12, 13, 14, 15, 16, or 17, wherein the DVB wall is recessed such that the metal material is present at both a bottom of the DVB wall on the bottom contact region and along sidewalls of the partially recessed portions.

Embodiment 19. A complementary field-effect transistor (CFET) array including a plurality of rows, columns, the CFET array comprising: a bottom contact region; a top contact region, the top contact region comprising a first contact line and a second contact line; a plurality of CFET cells, ones of the plurality of CFET cells located along particular ones of the plurality of columns and comprise a plurality of CFET transistors, the plurality of CFET transistors comprising a lower-level transistor layer on the bottom contact regions and an upper-level transistor layer beneath the top contact region; and a backside wall located adjacent to, and parallel with, one of the columns of the plurality of CFET cells, wherein along a given row of the plurality of rows, the backside wall comprises a noncontact area where the first contact line does not make contact with the backside wall, and wherein in the noncontact area, the backside wall comprises a metal material on the bottom contact region, and a dielectric material over the metal material that extends up to the top contact region.

Embodiment 20. The CFET array of Embodiment 19, wherein along another row of the plurality of rows, the backside wall comprises a contact area where the second contact lines makes contact with the backside wall, wherein in the contact area, the backside wall is filled with metal between the bottom contact region and the top contact region.

## Claims

1. A stacked complementary field-effect device transistor (CFET) device, comprising:
a bottom contact region;
a top contact region;
a first transistor layer of a first type over the bottom contact region;
a second transistor layer of a second type over the first transistor layer;
a top contact region over the second transistor layer; and
a backside wall extending between the top contact region and the bottom contact region, the backside wall adjacent to the top contact region, the transistor layer, and the second transistor layer, the backside wall comprising a partially recessed portion that includes a metal material on the bottom contact region and a dielectric material over the metal material that extends up to the top contact region.

2. The stacked CFET device of claim 1, wherein the top contact region comprises a metal line that does not make contact with the backside wall in the top contact region.

3. The stacked CFET device of claim 2, wherein a distance from the backside wall to the metal line in the top contact regions ranges from 10 - 25 nm.

4. The stacked CFET device of claim 1, 2 or 3, wherein the partially recessed portion of the backside wall ranges in height from 20 to 70 nm.

5. The stacked CFET device of claim 1, 2, 3 or 4, wherein the metal material ranges in height from 30 - 80 nm.

6. The stacked CFET device of claim 1, 2, 3, 4 or 5, the backside wall ranges from 100 - 150 nm in height between the bottom contact region and the top contact regions.

7. The stacked CFET device of claim 1, 2, 3, 4, 5 or 6, wherein the backside wall ranges from 20 - 40 nm in width on the bottom contact region.

8. The stacked CFET device of claim 1, 2, 3, 4, 5, 6 or 7, wherein the backside wall is recessed such that sidewalls of the partially recessed portion contain no metal material.

9. The stacked CFET device of claim 1, 2, 3, 4, 5, 6, 7 or 8, wherein the backside wall is recessed such that the metal material is present at both a bottom of the backside wall and along sidewalls of the partially recessed portions.

10. The stacked CFET device of claim 1, 2, 3, 4, 5, 6, 7, 8 or 9, wherein the first type is an N-type FET and the second type is a P-type FET.

11. The stacked CFET device of claim 1, 2, 3, 4, 5, 6, 7, 8, 9 or 10, wherein, the first type is a P-type FET and the second type is an N-type FET.

12. A method of fabricating a stacked complementary field-effect device transistor (CFET) device, the method comprising:
forming a bottom contact region;
forming a top contact region;
forming a first transistor layer of a first type over the bottom contact region;
forming a second transistor layer of a second type over the first transistor layer;
forming a top contact region over the second transistor layer; and
forming a backside wall extending between the top contact region and the bottom contact region, the backside wall adjacent to the top contact region, the transistor layer, and the second transistor layer, the backside wall comprising a partially recessed portion that includes a metal material on the bottom contact region and a dielectric material over the metal material that extends up to the top contact region.

13. The method of claim 12, wherein the top contact region comprises a metal line that does not make contact with the backside wall in the top contact region.

14. The method of claim 13, wherein a distance from the backside wall to the metal line in the top contact regions ranges from 10 - 25 nm.

15. The method of claim 12, 13 or 14, wherein the partially recessed portion of the backside wall ranges in height from 20 to 70 nm.
